# EUROPEAN PATENT SPECIFICATION

(11) **EP 3 705 898 B1**
(45) Date of publication and mention of the grant of the patent: **04.06.2025**
(21) Application number: 19161413.0
(22) Date of filing: 07.03.2019
(51) Int. Cl.: G01R 29/10, H01Q 1/32

(54) **MEASUREMENT SYSTEM FOR TESTING A SYSTEM UNDER TEST AS WELL AS MEASUREMENT SETUP**
MESSSYSTEM ZUM TESTEN EINES ZU TESTENDEN SYSTEM SOWIE MESSAUFBAU
SYSTÈME DE MESURE D'ESSAI D'UN SYSTÈME SOUMIS À ESSAI, AINSI QUE CONFIGURATION DE MESURE

(43) Date of publication of application: 09.09.2020
(73) Proprietor: Rohde & Schwarz GmbH & Co. KG, 81671 München (DE)
(72) Inventor: REIMER, Christian, 81671 München (DE); NASEEF, Mahmud, 81671 München (DE)
(74) Representative: Novagraaf Group

(56) References cited:
- CN-A- 102 818 954
- CN-U- 205 864 433
- DE-A1- 102006 009 634
- US-A1- 2017 012 714
- CARL W SIRLES ET AL: "A NOVEL SPHERICAL SCANNER SYSTEM FOR WIRELESS TELEMATICS MEASUREMENTS", 31 December 2009 (2009-12-31), XP055612228, Retrieved from the Internet <URL:http://thehowlandcompany.com/pdf/A_Novel_Spherical_Scanner_System_for_Telematics_Measurements.pdf> [retrieved on 20190812]
- PHILIPP BERLT ET AL: "Over-The-Air Testing of Automotive Antennas and Wireless Links in The Installed State on The Basis of LTE Downlink Communication Parameters", ADVANCES IN SCIENCE, TECHNOLOGY AND ENGINEERING SYSTEMS JOURNAL, 20 February 2019 (2019-02-20), XP055612238, Retrieved from the Internet <URL:https://www.astesj.com/publications/ASTESJ_040127.pdf> [retrieved on 20190808], DOI: 10.25046/aj040127

## Description

The invention concerns a measurement system for testing a system under test as well as a measurement setup comprising a measurement system and a system under test.

With the rise of the Internet of Things, ever more systems are provided with wireless connectivity for communication with other systems. For this purpose, the systems are provided with a wireless communication device that has to be compatible with a wireless network and other wireless communication devices.

An example of such a system may be a vehicle with a telematics unit.

CN 102 818 954 A describes an electromagnetic radiation emission real-time measurement system for high-speed electrical multiple units (EMU).

DE 10 2006 009 634 A1 describes a method diagnosing telematic systems during a production process of a vehicle.

US 2017/0012714 A1 discloses an apparatus for measuring over-the-air wireless communication performance in an automotive application of a device under test arranged on or in a vehicle.

Carl W Sirles ET AL: "A Novel Spherical Scanner System for Wireless Telematics Measurements" discloses a scanner system for measuring the radiation characteristics of antennas mounted on and in a vehicle.

In order to assure compatibility, the system has to undergo various tests, including a measurement of a radiation pattern, especially a radiation pattern of spurious emission.

However, as the systems, for example a housing or a chassis of the system, may interfere with its own communication device, tedious and time-consuming tests inside and outside of the system have to be performed.

Thus, it is the object of the invention to provide a measurement system and a measurement setup for testing a system under test that yield complete measurement results in a short amount of time.

For this purpose, a measurement system for testing of a system under test is provided, in particular a vehicle with a wireless communication device. The measurement system has a communication tester for establishing an over the air communication link with the system under test, a first test receiver for receiving a signal of the system under test, and a second test receiver for receiving the signal of the system under test. The first test receiver is configured to be disposed at a distance from the system under test and the second test receiver is configured to be disposed inside the system under test. The measurement system comprises a control unit connected to the first test receiver, the second test receiver and the communication tester.

By placing a test receiver outside of the system under test and another test receiver within the system under test, the measurements of the emission behavior of the communication device of the system under test may be evaluated simultaneously. Thus, the time needed for a measurement can be reduced significantly.

For example, the signal of the system under test is a spurious signal of the system under test, in order to measure the spurious emission of the system under test. Of course, the system under test may emit communication signals for communicating, e.g. with the communication tester, as well.

In an embodiment, the second test receiver is a portable device and/or the first test receiver is stationary. This way, the test receivers may easily deployed.

For example, the second test receiver is small and lightweight.

In order to reduce the disturbance of the measurements due to the second test receiver, the second test receiver is a power meter, in particular a frequency selective power meter. For example, the second power meter is EMC (electromagnetic compatibility) tested and does not emit significant spurious signals itself.

In an aspect of the invention, the first test receiver comprises a receive antenna and a spectrum analyzer in order to precisely determine the radiation pattern.

For increasing the accuracy even further, the first test receiver comprises a signal-conditioning unit connected between the spectrum analyzer and the receive antenna.

In order to provide a versatile preprocessing, the signal-conditioning unit comprises at least one amplifier, at least one filter and/or at least one switch matrix.

For example, the signal-conditioning unit may be a switch and control platform capable of performing radio frequency (RF) switch and control tasks.

In an aspect, the receive antenna comprises a transducer and a coupling device.

In an embodiment of the invention, the control unit is connected to the first rest receiver, to the second test receiver and to the communication tester via a cable-bound connection in order not to disturb the measurements.

For example, the second test receiver is connected to the control unit via a local area network (LAN).

In an embodiment of the invention, the measurement system comprises a rotation mechanism for the system under test, in particular a turntable for vehicles. This eliminates the need to move the first test receiver, reducing measurement time even further.

Further, for above purpose, a measurement setup for testing of a system under test is provided, the measurement setup comprising a measurement system as explained above and a system under test. The first test receiver is disposed outside and at a distance from the system under test, and the second test receiver is disposed inside the system under test.

The features and advantage discussed in the context of the measurement system also apply to the measurement setup and vice versa.

In an embodiment, the system under test is a vehicle having a wireless communication device, in particular a telematics unit. This way, measurements on a vehicle are possible.

For example, the communication tester is configured for establishing an over the air communication link with the telematics unit.

In order to assess spurious emission within the vehicle, the vehicle comprises a passenger cabin and the second test receiver is located within the passenger cabin.

To allow a quick measurement, the system under test is placed on the rotation mechanism.

Further features and advantages will be apparent from the following description as well as the accompanying drawings, to which reference is made. In the drawings:
- Figure 1 shows a measurement setup according to the invention including a measurement system according to the invention, and
- Figure 2 shows a radiation pattern of a system under test obtained using the measurement setup of Figure 1.

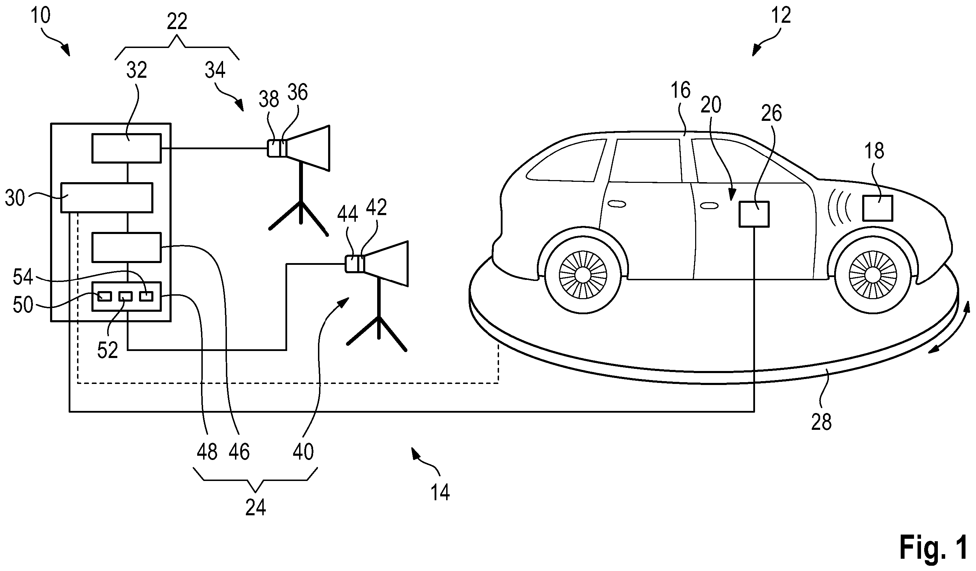

Figure 1 shows very schematically a measurement setup 10 comprising a system under test (SUT) 12 and a measurement system 14.

The system under test 12 is a vehicle 16, for example a passenger car, in the shown embodiment.

The vehicle 16 comprises a wireless communication device 18, for example a telematics unit, and a passenger cabin 20.

The measurement system 14 comprises a communication tester 22, a first test receiver 24, a second test receiver 26, a rotation mechanism 28, for example a turntable, and a control unit 30.

The communication tester 22 and the first test receiver 24 may also comprise amplifiers or amplifying stages, which are not shown for the sake of simplicity.

The measurement system 14 is configured to test the system under test 12, especially for measuring the radiation pattern. For example the radiation pattern of spurious signals of the system under test 12, in the shown embodiment of spurious signals of the communication device 18 of the vehicle 16.

The communication tester 22 is configured to establish an over the air (OTA) communication link with the system under test 12, in particular with the wireless communication device 18 of the vehicle 16.

The communication tester 22 comprises a signal generator 32 and a communication antenna 34. The communication antenna 34 may have a transducer 36 and a coupling device 38.

The signal generator 32 and the communication antenna 34 are connected via a cable.

The first test receiver 24 comprises a receive antenna 40 having a transducer 42 and a coupling device 44, a signal-conditioning unit 46 and a spectrum analyzer 48.

The signal-conditioning unit 46 has at least one amplifier 50, at least one filter 52 and at least one switch matrix 54.

The signal-conditioning unit 46 is a switch and control platform and may be used to perform radio frequency switch and control tasks.

The receive antenna 40 is connected to the signal-conditioning unit 46, which is in turn connected to the spectrum analyzer 48. All of these connections are electrically connections via a cable.

The first test receiver 24, especially the receive antenna 40, is stationary and may be disposed with a distance to the system under test 12.

The second test receiver 26 is a portable device, meaning that it is a small and lightweight device.

The second test receiver 26 comprises a frequency selective power meter, for example a Rhode & Schwarz NRQ6, and an antenna.

The second test receiver 26 is EMC (electromagnetic compatibility) tested, meaning that it does not emit spurious signals itself, in any case, it emits less spurious signals than a tabletop spectrum analyzer.

The second test receiver 26 is configured to be disposed inside the system under test 12 without problems due to its small size and/or its electromagnetic compatibility.

The control unit 30 is configured to control the communication tester 22, the first test receiver 24 and the second test receiver 26. The control unit 30 is therefore connected via a cable-bound connection to the communication tester 22, more precisely the signal generator 32, to the first test receiver 24, more precisely the spectrum analyzer 48, and to the second test receiver 26.

The cable-bound connection between the control unit 30 and the second test receiver 26 may be via a local area network (LAN).

Further, the control unit 30 is connected to and controls the rotation mechanism 28. For measuring the radiation pattern of spurious emissions of the system under test 12, in the shown example the vehicle 16, system under test 12 (the vehicle 16) is placed on the rotation mechanism 28, here the turntable.

Further, the first test receiver 24, more precisely the receive antenna 40 is setup outside of and at a distance to the system under test 12 and to the rotation mechanism 28. Preferably, the receive antenna 40 is not moved during the measurement.

Likewise, the communication tester 22, particularly the communication antenna 34 is placed stationarily outside of the system under test 12 and the rotation mechanism 28.

The second test receiver 26 is placed within the system under test 12, for example within the passenger cabin 20 of the vehicle 16.

For measuring, the control unit 30 controls the communication tester 22 to establish an over the air communication link with the system under test 12, in the shown embodiment the communication device 18 of the vehicle 16.

The communication link is maintained at the stable condition throughout the measurement. Thus, the communication between the system under test 12 and the communication tester 22 is continuous and without intermissions.

During the communication of the communication tester 22 and the communication device 18, the communication device 18 generates spurious emissions that are picked up as spurious signals by the first test receiver 24, more precisely the receive antenna 40, and the second test receiver 26.

For a complete measurement of the radiation pattern, the system under test 12 is rotated a full 360° using the rotation mechanism 28 while the measurement is in progress.

Due to the fact, that the receive antenna 40 is stationary, the spurious emissions in all directions are measured.

At the same time, the spurious signals within the system under test 12 are picked up by the second test receiver 26.

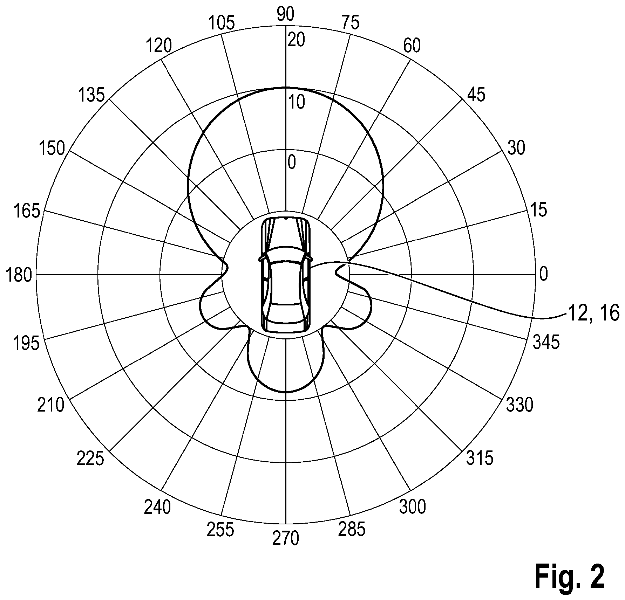

The spurious signals picked up by the receive antenna 40 are preprocessed by the signal-conditioning unit 46 and analyzed by the spectrum analyzer 48. The control unit 30 then receives the measurement results of the spectrum analyzer 48 and the second test receiver 26 and generates, inter alia, a radiation pattern of spurious emissions of the system under test 12, an example of which can be seen in Figure 2.

For example, three measurement points for each degree may be recorded.

Thus, a radiation pattern of spurious emissions can be obtained in a quick and reliable way without losing information about the conditions within the system under test 12 because of the second test receiver 26.

## Claims

1. Measurement system for testing of a system under test (12), in particular a vehicle (16) with a wireless communication device (18), the measurement system (14) having:
a communication tester (22) for establishing an over the air communication link with the system under test (12),
a first test receiver (24) for receiving a signal of the system under test (12), wherein the first test receiver (24) is configured to be disposed at a distance from the system under test (12),
wherein the measurement system comprises a second test receiver (26) for receiving the signal of the system under test (12), wherein the second test receiver (26) is configured to be disposed inside the system under test (12)
**characterized in that** the measurement system (14) comprises a control unit (30) connected to the first test receiver (24), the second test receiver (26) and the communication tester (22).

2. Measurement system according to claim 1, **characterized in that** the signal of the system under test (12) is a spurious signal of the system under test (12).

3. Measurement system according to claim 1 or 2, **characterized in that** the second test receiver (26) is a portable device and/or the first test receiver (24) is stationary.

4. Measurement system according to any one of the preceding claims, **characterized in that** the second test receiver (26) is a power meter, in particular a frequency selective power meter.

5. Measurement system according to any one of the preceding claims, **characterized in that** the first test receiver (24) comprises a receive antenna (40) and a spectrum analyzer (48).

6. Measurement system according to any one of the preceding claims, **characterized in that** the first test receiver (24) comprises a signal-conditioning unit (46) connected between the spectrum analyzer (48) and the receive antenna (40).

7. Measurement system according to claim 6, **characterized in that** the signal-conditioning unit (46) comprises at least one amplifier (50), at least one filter (52) and/or at least one switch matrix (54).

8. Measurement system according to claim 6 or 7, **characterized in that** the receive antenna (40) comprises a transducer (42) and a coupling device (44).

9. Measurement system according to any one of the preceding claims, **characterized in that** the control unit (30) is connected to the first test receiver (24), the second test receiver (26) and the communication tester (22) via a cable-bound connection.

10. Measurement system according to any one of the preceding claims, **characterized in that** the measurement system (14) comprises a rotation mechanism (28) for the system under test (12), in particular a turntable for vehicles (16).

11. Measurement setup for testing of a system under test (12), the measurement setup (10) comprising a measurement system (14) according to any one of the preceding claims and a system under test (12),
wherein the first test receiver (24) is disposed outside and at a distance from the system under test (12), and
wherein the second test receiver (26) is disposed inside the system under test (12).

12. Measurement setup according to claim 11, **characterized in that** the system under test (12) is a vehicle (16) having a wireless communication device (18), in particular a telematics unit.

13. Measurement setup according to claim 12, **characterized in that** the vehicle (16) comprises a passenger cabin (20) and the second test receiver (26) is located within the passenger cabin (20).

14. Measurement setup according to any one of the claims 11 to 13, **characterized in that** the system under test (12) is placed on the rotation mechanism (28).

## Patentansprüche

1. Messsystem zum Testen eines zu testenden Systems (12), insbesondere eines Fahrzeugs (16) mit einer drahtlosen Kommunikationsvorrichtung (18), das Messsystem (14) aufweisend:
einen Kommunikationstester (22) zum Herstellen einer Funkkommunikationsverknüpfung mit dem zu testenden System (12),
einen ersten Testempfänger (24) zum Empfangen eines Signals des zu testenden Systems (12), wobei der erste Testempfänger (24) konfiguriert ist, um in einem Abstand von dem zu testenden System (12) eingerichtet zu sein,
wobei das Messsystem einen zweiten Testempfänger (26) zum Empfangen des Signals des zu testenden Systems (12) umfasst, wobei der zweite Testempfänger (26) konfiguriert ist, um im Inneren des zu testenden Systems (12) eingerichtet zu sein,
**dadurch gekennzeichnet, dass** das Messsystem (14) eine Steuereinheit (30) umfasst, die mit dem ersten Testempfänger (24), dem zweiten Testempfänger (26) und dem Kommunikationstester (22) verbunden ist.

2. Messsystem nach Anspruch 1, **dadurch gekennzeichnet, dass** das Signal des zu testenden Systems (12) ein Störsignal des zu testenden Systems (12) ist.

3. Messsystem nach Anspruch 1 oder 2, **dadurch gekennzeichnet, dass** der zweite Testempfänger (26) eine tragbare Vorrichtung ist und/oder der erste Testempfänger (24) stationär ist.

4. Messsystem nach einem der vorstehenden Ansprüche,
**dadurch gekennzeichnet, dass** der zweite Testempfänger (26) ein Leistungsmesser, insbesondere ein frequenzselektiver Leistungsmesser ist.

5. Messsystem nach einem der vorstehenden Ansprüche,
**dadurch gekennzeichnet, dass** der erste Testempfänger (24) eine Empfangsantenne (40) und einen Spektrumanalysator (48) umfasst.

6. Messsystem nach einem der vorstehenden Ansprüche,
**dadurch gekennzeichnet, dass** der erste Testempfänger (24) eine Signalaufbereitungseinheit (46) umfasst, die zwischen dem Spektrumanalysator (48) und der Empfangsantenne (40) verbunden ist.

7. Messsystem nach Anspruch 6, **dadurch gekennzeichnet, dass** die Signalaufbereitungseinheit (46) mindestens einen Verstärker (50), mindestens ein Filter (52) und/oder mindestens eine Schaltmatrix (54) umfasst.

8. Messsystem nach Anspruch 6 oder 7, **dadurch gekennzeichnet, dass** die Empfangsantenne (40) einen Wandler (42) und eine Kopplungsvorrichtung (44) umfasst.

9. Messsystem nach einem der vorstehenden Ansprüche,
**dadurch gekennzeichnet, dass** die Steuereinheit (30) mit dem ersten Testempfänger (24), dem zweiten Testempfänger (26) und dem Kommunikationstester (22) über eine kabelgebundene Verbindung verbunden ist.

10. Messsystem nach einem der vorstehenden Ansprüche,
**dadurch gekennzeichnet, dass** das Messsystem (14) einen Drehmechanismus (28) für das zu testende System (12), insbesondere eine Drehscheibe für Fahrzeuge (16), umfasst.

11. Messaufbau zum Testen eines zu testenden Systems (12), der Messaufbau (10) umfassend ein Messsystem (14) nach einem der vorstehenden Ansprüche und ein zu testendes System (12),
wobei der erste Testempfänger (24) außerhalb und in einem Abstand von dem zu testenden System (12) eingerichtet ist, und
wobei der zweite Testempfänger (26) im Inneren des zu testenden Systems (12) eingerichtet ist.

12. Messaufbau nach Anspruch 11, **dadurch gekennzeichnet, dass** das zu testende System (12) ein Fahrzeug (16) ist, das eine drahtlose Kommunikationsvorrichtung (18), insbesondere eine Telematikeinheit, aufweist.

13. Messaufbau nach Anspruch 12, **dadurch gekennzeichnet, dass** das Fahrzeug (16) eine Passagierkabine (20) umfasst und der zweite Testempfänger (26) sich innerhalb der Passagierkabine (20) befindet.

14. Messaufbau nach einem der Ansprüche 11 bis 13,
**dadurch gekennzeichnet, dass** das zu testende System (12) auf dem Drehmechanismus (28) platziert wird.

## Revendications

1. Système de mesure permettant de tester un système soumis à un test (12), en particulier un véhicule (16) avec un dispositif de communication sans fil (18), le système de mesure (14) ayant :
un dispositif de test de communication (22) pour établir une liaison de communication par radio avec le système soumis à un test (12),
un premier récepteur de test (24) pour recevoir un signal du système soumis à un test (12), dans lequel le premier récepteur de test (24) est configuré pour être disposé à une certaine distance du système soumis à un test (12),
dans lequel le système de mesure comprend un second récepteur de test (26) pour recevoir le signal du système soumis à un test (12), dans lequel le second récepteur de test (26) est configuré pour être disposé à l'intérieur du système soumis à un test (12)
**caractérisé en ce que** le système de mesure (14) comprend une unité de commande (30) connectée au premier récepteur de test (24), au second récepteur de test (26) et au dispositif de test de communication (22).

2. Système de mesure selon la revendication 1, **caractérisé en ce que** le signal du système soumis à un test (12) est un signal parasite du système soumis à un test (12).

3. Système de mesure selon la revendication 1 ou 2, **caractérisé en ce que** le second récepteur de test (26) est un dispositif portable et/ou le premier récepteur de test (24) est stationnaire.

4. Système de mesure selon l'une quelconque des revendications précédentes, **caractérisé en ce que** le second récepteur de test (26) est un wattmètre, en particulier un wattmètre sélectif en fréquence.

5. Système de mesure selon l'une quelconque des revendications précédentes, **caractérisé en ce que** le premier récepteur de test (24) comprend une antenne de réception (40) et un analyseur de spectre (48).

6. Système de mesure selon l'une quelconque des revendications précédentes, **caractérisé en ce que** le premier récepteur de test (24) comprend une unité de conditionnement de signal (46) connectée entre l'analyseur de spectre (48) et l'antenne de réception (40).

7. Système de mesure selon la revendication 6, **caractérisé en ce que** l'unité de conditionnement de signal (46) comprend au moins un amplificateur (50), au moins un filtre (52) et/ou au moins une matrice de commutation (54).

8. Système de mesure selon la revendication 6 ou 7, **caractérisé en ce que** l'antenne de réception (40) comprend un transducteur (42) et un dispositif de couplage (44).

9. Système de mesure selon l'une quelconque des revendications précédentes, **caractérisé en ce que** l'unité de commande (30) est connectée au premier récepteur de test (24), au second récepteur de test (26) et au dispositif de test de communication (22) par l'intermédiaire d'une connexion câblée.

10. Système de mesure selon l'une quelconque des revendications précédentes, **caractérisé en ce que** le système de mesure (14) comprend un mécanisme de rotation (28) du système soumis à un test (12), en particulier une table tournante pour véhicules (16).

11. Installation de mesure permettant de tester un système soumis à un test (12), l'installation de mesure (10) comprenant un système de mesure (14) selon l'une quelconque des revendications précédentes et un système soumis à un test (12),
dans laquelle le premier récepteur de test (24) est disposé à l'extérieur et à une certaine distance du système soumis à un test (12), et
dans laquelle le second récepteur de test (26) est disposé à l'intérieur du système soumis à un test (12).

12. Installation de mesure selon la revendication 11, **caractérisée en ce que** le système soumis à un test (12) est un véhicule (16) ayant un dispositif de communication sans fil (18), en particulier une unité télématique.

13. Installation de mesure selon la revendication 12, **caractérisée en ce que** le véhicule (16) comprend un habitacle (20) et le second récepteur de test (26) est situé dans l'habitacle (20).

14. Installation de mesure selon l'une quelconque des revendications 11 à 13, **caractérisée en ce que** le système soumis à un test (12) est placé sur le mécanisme de rotation (28).
